# EUROPÄISCHE PATENTSCHRIFT

(11) **EP 0 490 028 B1**
(45) Veröffentlichungstag und Bekanntmachung des Hinweises auf die Patenterteilung: **26.06.1996**
(21) Anmeldenummer: 91114757.7
(22) Anmeldetag: 02.09.1991
(51) Int. Cl.: C23C 16/50, C23C 16/30, C23C 16/02, F21V 7/22

(54) **Schichtsystem auf Oberflächen von Werkstoffen und Verfahren für seine Herstellung**
Coatingsystem on the surface of a material and process for its fabrication
Système de couches sur la surface d'un matériau et procédé pour sa fabrication

(30) Priorität: 10.12.1990 DE 4039352
(43) Veröffentlichungstag der Anmeldung: 17.06.1992
(73) Patentinhaber: LEYBOLD AKTIENGESELLSCHAFT, D-63450 Hanau (DE)
(72) Erfinder: Geisler, Michael, Dr., W-6480 Wächtersbach (DE); Kötter-Faulhaber, Rudolf, W-6367 Karben 6 (DE); Wuerz, Susanne, W-6451 Neuberg (DE); Jung, Michael, W-8756 Kahl/Main (DE)
(74) Vertreter: Sartorius, Peter, Dipl.-Ing. Patentanwalt

(56) Entgegenhaltungen:
- EP-A- 0 279 895
- DE-A- 3 731 686
- DE-A- 3 942 325
- THIN SOLID FILMS Bd. 118, Nr. 2, 1. August 1984, Lausanne CH, Seiten 211-224, Y. MATSUDA ET AL: 'EVALUATION OF PLASMA POLYMERS OF SILANES AS ADHESION PROMOTERS FOR ORGANIC PAINT'

## Beschreibung

Die Erfindung bezieht sich auf ein abriebfestes Schichtsystem auf einem Werkstoff, insbesondere Kunststoff, mit drei Schichten, wobei die erste auf dem Substrat vorgesehene Schicht und die dritte bzw. oberste Schicht neben H und C Si und/oder O enthält, während die zweite Schicht aus Metall besteht.

Es ist bereits ein Verfahren zur Herstellung einer Schutzschicht auf der Oberfläche optischer Aluminiumreflektoren bekannt (DE-AS 26 25 448), die in einem Vakuumrezipienten beschichtet werden. Hierzu werden die Reflektoren einem monomeren Dampf organischer Verbindungen ausgesetzt, wobei die Schutzschicht durch Polymerisation aus der Dampfphase mit Hilfe der Strahlung aus einer elektrischen Gasentladung abgeschieden wird. Die Schutzschicht ist aus einer siliziumorganischen Substanz gebildet. Hierdurch sollen optische Reflektoren mit guten korrosionsschützenden und optischen Eigenschaften geschaffen werden.

Bekannt ist ferner eine Einrichtung zum Herstellen eines Plasmas und zur Behandlung von Substraten (DE-OS 37 05 666), bei der mit Hilfe einer Mikrowellen ECR-Plasmaquelle ein Beschichtungsprozeß auf einem bandförmigen Substrat durchgeführt wird.

Außerdem ist ein Verfahren zur Herstellung einer korrosionsfesten Schicht auf der Oberfläche von mit Lack und Metall überzogenen Werkstücken bekannt (DE-OS 37 31 686), bei dem in einer Vakuumkammer mit Hilfe einer Glimmkathode und eines Verdampfers ein Schichtsystem auf die Werkstücke aufgebracht wird.

Bei diesem vorbekannten Verfahren bestehen die für den Korrosionsschutz geeigneten Schichten aus elektrisch nicht bzw. sehr schlecht leitendem Material. Oberhalb einer Dicke von ca. 100 nm sind diese Schichten gute Isolatoren. Beim Betrieb der herkömmlichen Anlagen zur Schutzbeschichtung von KFZ-Reflektoren, die mit Gleichspannung betrieben werden, bilden sich während des Beschichtungsprozesses auf den Elektroden stetig wachsende Schichten, die innerhalb kurzer Zeit die für die elektrische Leitfähigkeit kritische Dicke erreicht haben und isolierende Eigenschaften erhalten. Sie verhindern damit die Aufrechterhaltung der mit Gleichspannung betriebenen Glimmentladung. Zur wiederaufbereitenden Reinigung der Elektroden muß die Prozeßkammer nach wenigen Chargen geflutet werden. Erfahrungsgemäß ist das Fluten einer Prozeßkammer immer mit einer enormen Partikelgeneration verbunden, die jedesmal eine aufwendige Reinigung der gesamten Kammer notwendig macht.

Die bei der DC-PCVD eingesetzte Glimmentladung wird im Druckbereich von einigen Pascal betrieben. Die Strömungsverhältnisse sind in diesem Druckbereich in jedem praktischen Falle hochviskos, turbulent und daher schwer überschau- und beherrschbar. Unter diesen Verhältnissen eine gleichmäßige Schichtdicke zu erreichen, ist fast nicht möglich.

Ferner ist aus der EP 279 895 A3 eine Einrichtung zur Erzeugung eines Plasmas und zur Behandlung von Substraten bekannt. Das mit Hilfe von Mikrowellen erzeugte Plasma dient dazu, ein Substrat zu beschichten, das sich in einer Kammer aus metallischen Wänden befindet. Die Anlage zur Beschichtung im Mikrowellenplasma wird zunächst auf einen Restdruck von sehr kleinen Drücken evakuiert. Anschließend wird Silangas mit einem solchen Gasfluß eingelassen, daß sich ein Silangaspartialdruck von 2 x 10⁻³ mbar einstellt.

Aus der Druckschrift "Journal of Applied Polymer Science, Applied Polymer Symposium 38, pp 185-191 (1984)" von W.O. Freitag, H. Yasuda, A.K. Sharma, ist es bekannt, korrosionsbeständige Schichten zu erstellen, die relativ dick sind. Das Problem der Abriebfestigkeit ist bei der Erstellung der Schichten ohne Bedeutung.

Demgemäß besteht die Erfindungsaufgabe darin, ein plasmagestütztes, vakuumtechnisches Verfahren so weiterzubilden, daß eine wisch- und waschfeste Oberfläche auf einem Substrat kostengünstig hergestellt werden kann.

Gelöst wird die Aufgabe erfindungsgemäß dadurch, daß die erste und dritte Schicht eine Dicke kleiner als 20 nm aufweisen.

Mit einer solchen Auswahl der Dicke der Schichten wird überraschend eine deutlich höhere Abriebfestigkeit des Schichtsystems erreicht als bei den üblichen Schichtdicken, die im Bereich von 150 nm liegen.

Vorteilhaft ist ferner, daß die zweite aus Metall gebildete Schicht eine Dicke zwischen 80 und 100 nm aufweist und daß die erste zwischen dem Substrat und der zweiten Schicht bzw. Metallschicht vorgesehene Vorschicht eine Schichtdicke aufweist, die kleiner als 5 nm ist. Aufgrund der außerordentlich kleinen Schichtdicken wird wesentlich weniger Material und vor allen Dingen weniger Zeit gebraucht, so daß hierdurch erheblich kostengünstigere Schichten hergestellt werden können, als das bisher möglich war.

In weiterer Ausgestaltung der Erfindung ist es vorteilhaft, daß die dritte Schicht, die auf der Metallschicht vorgesehen ist, eine Schichtdicke aufweist, die kleiner als 5 nm ist, und daß die erste Schicht und/oder die dritte Schicht vorwiegend C enthält.

Vorteilhaft ist es außerdem, daß die erste Schicht und/oder die dritte Schicht vorwiegend C und H ferner Si und O bis zu einem Verhältnis von jeweils 1:1 zu C enthält und daß die erste Schicht und/oder die dritte Schicht einen C-Bestandteil von mehr als 50 % aufweist.

Ferner ist es vorteilhaft, daß die erste Schicht und/oder die dritte Schicht einen C-Bestandteil, einen Si-Anteil und einen O-Anteil zu gleichen Teilen enthält. Durch diese Weiterbildung dieses erfindungsgemäßen Schichtaufbaus wird eine noch wischfestere Oberfläche auf dem Substrat abgeschieden.

Die Erfindung betrifft außerdem ein Verfahren zum Aufbringen des Schichtsystems gemäß Anspruch 1. Das erfindungsgemäße Verfahren besteht darin, daß auf der Substratoberfläche eine Vorschicht, dann die Metallschicht und anschließend eine Schutzschicht unter Plasma bei Drücken unterhalb von 0,5 mbar aufgebracht wird, wobei die Vor- und/oder Schutzschicht mit Hilfe des PCVD-Verfahrens aufgebracht wird, und daß die Glimmentladung mit einem elektrischen Wechselfeld angeregt wird.

Besonders vorteilhaft ist es, daß die Glimmentladung mit einer Frequenz im Mikrowellenbereich angeregt und die erste Schicht bzw. Vorschicht im PCVD-Verfahren, die zweite Schicht im Aufdampfverfahren und die dritte Schicht im PCVD-Verfahren aufgebracht wird.

Eine zusätzliche Möglichkeit ist gemäß einer Weiterbildung des erfindungsgemäßen Verfahrens, daß die erste Schicht einer Temperierung in Luft bei Temperaturen, insbesondere unter 200 °C, unterzogen wird und daß die erste Schicht und/oder die dritte Schicht bei einem Prozeßdruck zwischen 0,5 µbar und 100 µbar, insbesondere zwischen 1,0 µbar und 30 µbar, mit einem Hexamethyldisiloxan enthaltenden Prozeßgas bei einer Mikrowellenleistungsdichte zwischen 0,3 und 50 Watt/cm², insbesondere 4 Watt/cm², gebildet wird.

Vorteilhaft ist es ferner, daß die zweite Schicht als Aluminiumschicht ausgebildet ist und in einer Vakuumkammer bei Drücken unterhalb von 0,05 mbar durchgeführt wird.

Außerdem ist es vorteilhaft, daß die erste Schicht aus einer Gasatmosphäre auf die Substratoberfläche aufgebracht wird, wobei die Gasatmosphäre Moleküle enthält, die Si,C, und/oder Si,O,C, enthalten.

Außerdem ist es vorteilhaft, daß eine Si,C- bzw. Si,O,C-Schutzschicht bzw. die dritte Schicht in einer in der Vakuumkammer eingestellten O₂-haltigen Atmosphäre auf der Oberfläche oxidiert wird.

In weiterer Ausgestaltung der Erfindung ist es vorteilhaft, daß auf der Substratoberfläche eine Vorschicht, dann die Metallschicht und anschließend eine Schutzschicht unter Plasma bei Drücken zwischen 0,8 µbar und 2 µbar aufgebracht wird oder daß auf der Substratoberfläche eine Vorschicht, dann die Metallschicht und anschließend eine Schutzschicht unter Plasma bei Drücken zwischen 0,1 µbar und 0,1 mbar aufgebracht wird.

Vorteilhaft ist es ferner, das die Substrate nach dem Metallisieren ihrer Oberfläche auf eine Vorspannung, insbesondere auf eine negative Vorspannung, gelegt werden.

Außerdem ist es vorteilhaft, daß die Substrate vor und/oder während des Beschichtungsvorgangs beheizt werden und daß die Energiequelle bzw. der Plasmagenerator im Pulsbetrieb betrieben wird.

In den Figuren ist die Erfindung an einer Ausführungsform beispielsweise dargestellt, ohne auf diese Ausführungsform beschränkt zu sein. Es zeigt:
- Figur 1: eine Vorrichtung zur Beschichtung von Vorderflächenspiegeln einer aus einer Mikrowellenquelle, einer Vakuumkammer mit Einbauten und einem Vakuumpumpenstand gebildeten Anlage im Schnitt,
- Figur 2: eine perspektivische Darstellung einer Batchanlage,
- Figur 3: eine Hornantenne und einen Ausschnitt in perspektivischer Sicht,
- Figur 4: eine Vorrichtung gemäß Figur 1 mit in axialer Richtung angeordneter Plasmaquelle im Querschnitt,
- Figur 5: eine Vorrichtung gemäß Figur 1 mit ringförmig angeordneten Plasmaquellen im Schnitt,
- Figur 6: eine Teilansicht der Batchanlage gemäß Figur 2,
- Figur 7: eine Anordnung der Gasverteilungsrohre in der Vakuumkammer im Schnitt.
- Figur 8: eine schematische Darstellung einer Bürstentestvorrichtung,
- Figur 9: eine schematische Darstellung des Substrats mit einer haftvermittelnden Metall- und einer Schutzschicht.

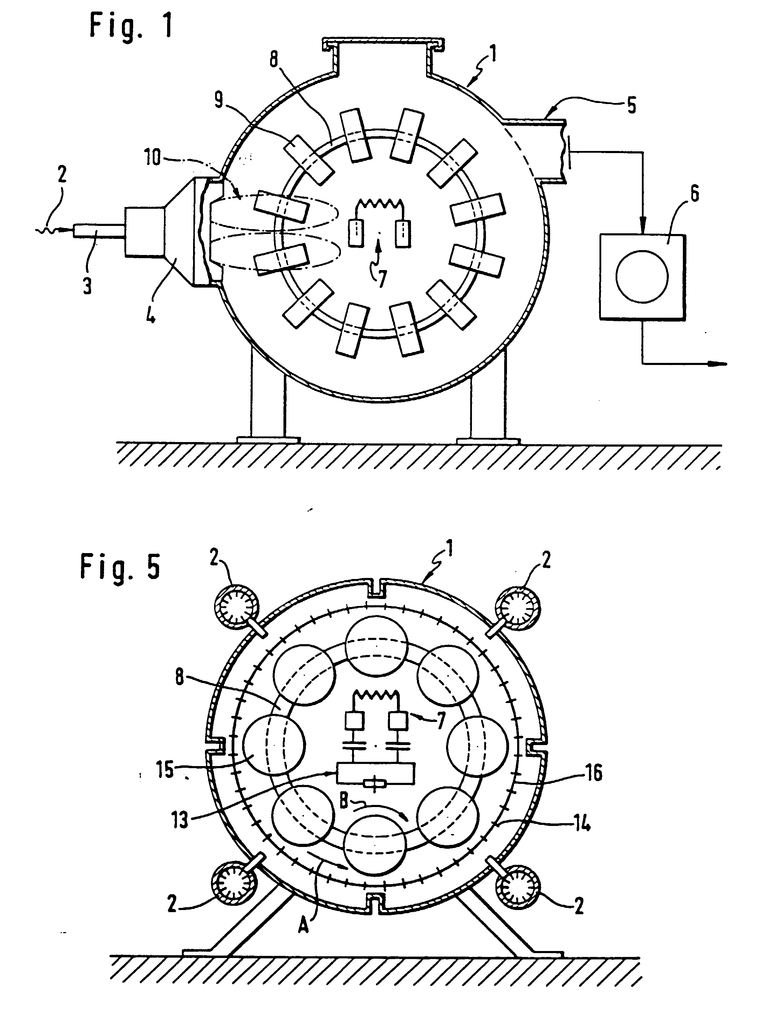

Wie Figur 1 zeigt, sind an einer zylindrischen und horizontal angeordneten Vakuumkammer 1 eine Mikrowellenquelle 2, ein Hohlleiter 3 und eine Hornantenne 4 oder eine Hochfrequenzantenne anderer Bauart axial auf einer Seite der Kammer angebaut und ein Verteilerkasten 5 sowie eine Hochvakuumpumpe 6 an der gegenüberliegenden Seite der Kammer angeschlossen. In der Kammer 1 ist zentral und in axialer Richtung eine Verdampferbank 7 befestigt.

Koaxial um diese Verdampferbank 7 ist ein hohlzylindrischer Drehkäfig 8 angeordnet, der die zu beschichtenden Substrate 9 auf seinem Umfang aufnimmt und durch das in der Vakuumkammer 1 ortsfest erzeugte Plasma 10 hindurch- oder an ihm vorbeibewegt.

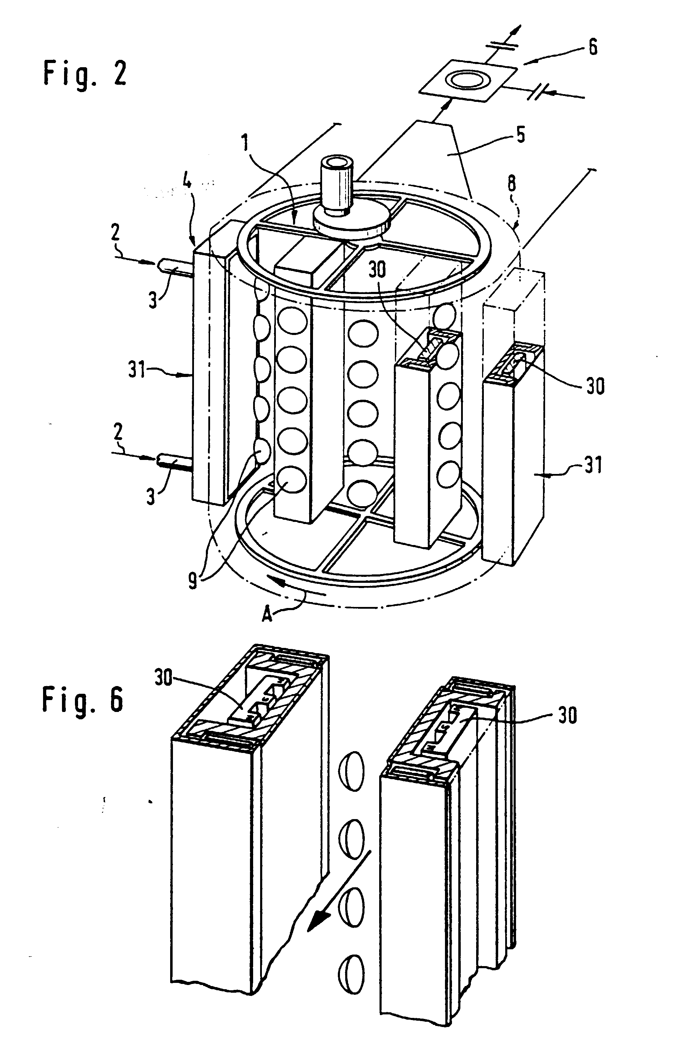

An der hier gezeigten Vakuumkammer 1 gemäß Figur 2 sind je 2 Stück Mikrowellenquellen 2, und Hohlleiter 3 vorgesehen. Der Verteilerkasten 5 ist zur räumlichen Verteilung des Saugvermögens der Hochvakuumpumpe 6 an der Längsseite der Vakuumkammer 1 mittig angeschlossen. Die zu beschichtenden Substrate 9 sind am Umfang und über die gesamte Länge des Drehkäfigs angeordnet (Figur 2).

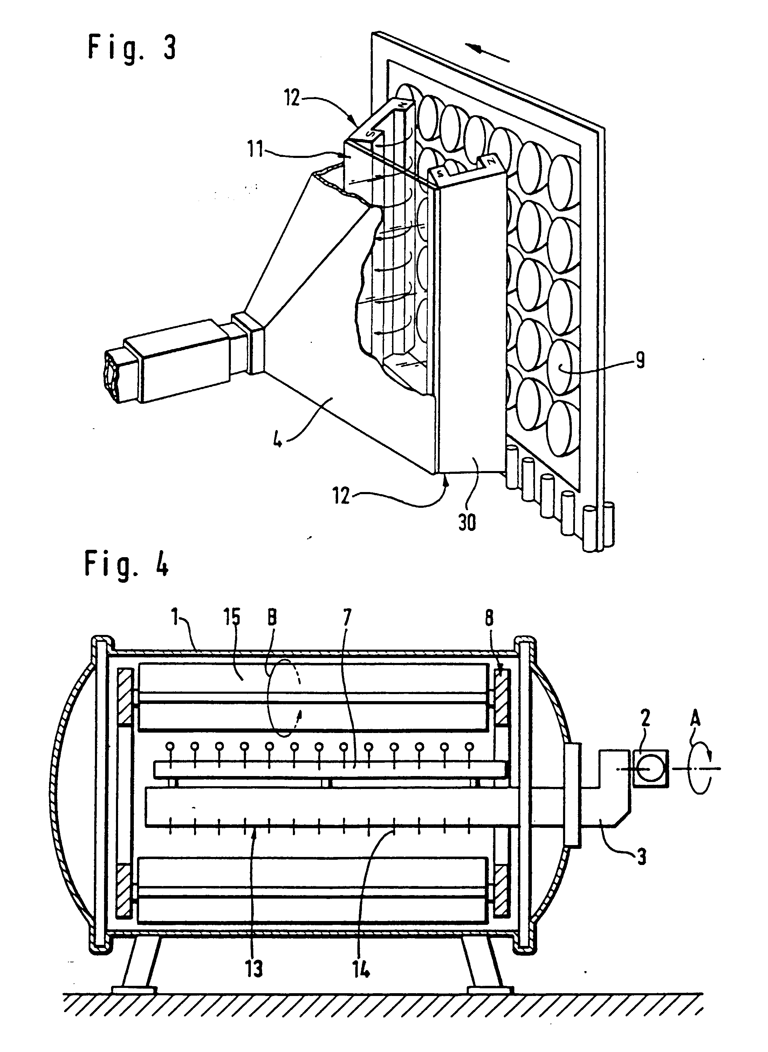

Die größere Öffnung der Hornantenne 4 ist mit einem Quarzfenster 11 abgeschlossen, an das sich die Magnetsysteme 12 anschließen. Die Hornantenne 4 ist lotrecht auf die Oberfläche des Drehkäfigs 8 ausgerichtet, auf der die Substrate 9 befestigt sind (Figur 3).

Gemäß Figur 4 ist die Mikrowellenquelle 2 stirnseitig an einer Vakuumkammer 1 angeordnet und mit einem Mikrowellenhohlleiter 3 verbunden, der wiederum an eine sich in axialer Richtung der Vakuumkammer 1 erstreckenden Mikrowellen-Antennenstruktur 13 angeschlossen ist. Diese Antenne 13 ist mit sich wiederholenden Koppelelementen 14 versehen.

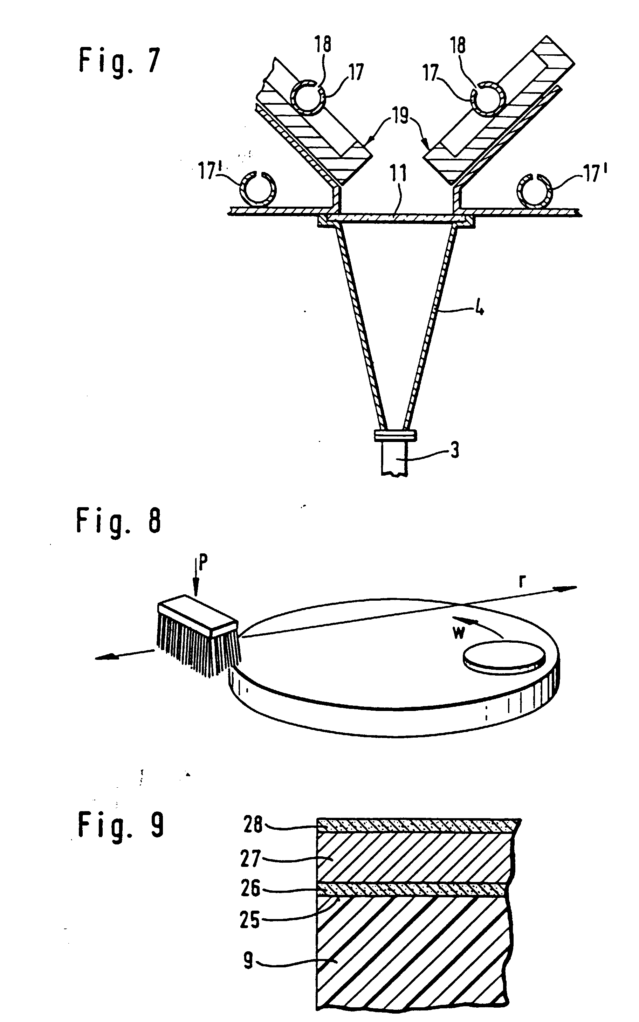

Oberhalb und parallel der Mikrowellenstruktur 13 ist eine Verdampferbank 7 angeordnet. Ein Drehkäfig 8 (Figur 5) ist um die gedachte zentrale Kammerlängsachse in Bewegungsrichtung A drehbar gelagert. Die am Umfang des Käfigs 8 planetenartig angeordneten Haltemittel 15 dienen zur Aufnahme der Substrate und führen eine weitere Drehbewegung in Bewegungsrichtung B um eine mit dem Käfig umlaufende Drehachse aus (Figur 4 oder 5).

In Figur 5 sind die Magnetsysteme 12 azimutal verteilt an der Vakuumkammer 1 befestigt und die mit den Koppelelementen 14 versehene Mikrowellen-Antennenstruktur 16 ist koaxial zum Drehkäfig 8 und zwischen diesem und der Kammerwand angeordnet.

Die Winkelgeschwindigkeit um die zentrale Kammerachse und um die Planetenachse ist vorzugsweise im Drehsinn gegenläufig.

Die Gasverteilungsrohre 17 (Figur 7) zur Zuführung von Prozeßgas in die Vakuumkammer 1 sind mit sich wiederholenden Bohrungen 18 versehen und zwischen den freien Magnetpolen 19 befestigt. Ein zweites Prozeßgas wird mit Hilfe der in Höhe der Magnetpole 19 angeordneten Gasverteilungsrohre 17' in die Vakuumkammer eingeleitet (Figur 7).

Es wird beispielsweise mit Vorteil eine Mikrowellen-ECR-Plasmaquelle eingesetzt. Mit diesem Plasmagenerator wird die Energie aus einem Mikrowellenfeld (z.B. 2,45 GHz oder 900 MHz) verwendet, um die Glimmentladung aufrechtzuerhalten. Die Mikrowellen werden in einem konventionellen Magnetron erzeugt und über einen Hohlleiter in eine Antenne 4 (z.B. eine Hornantenne) eingespeist. Diese Antenne 4 übernimmt gleichzeitig auch die Funktion der hochvakuumdichten Trennung des Hohlleiterbereichs vom Inneren der evakuierten Prozeßkammer, an die sie angeflanscht ist (siehe Figuren 1 und 2).

Vakuumseitig wird die Antenne 16 von einem ringförmigen Magnetjoch umrahmt, das mit Permanentmagneten 30 bestückt ist. Dieses Magnetsystem erzeugt ein in sich geschlossenes tunnelförmiges Magnetfeld. Dieses Magnetfeld ist so dimensioniert, daß es in einem gewissen Bereich zwischen den freien Polflächen der Magnete die Elektrozyklotron-Resonanzbedingung für die verwendete Mikrowellenfrequenz erfüllt.

Durch den Resonanzeffekt wird der Energieübertrag vom Mikrowellenfeld zu den im Plasma 10 enthaltenen Elektronen sehr effizient verstärkt. Die Folge ist eine im Vergleich zu DC- oder rf-betriebenen Plasmen äußerst hohe Reaktivität der Schwerteilchen.

Abgesehen von dem im Magnetfeld erzeugten Resonanzeffekt, vermindert das Magnetfeld auch noch Verluste durch Diffusion der Ladungsträger (containment) und erzeugt im vorliegenden Falle schließlich infolge von Driftbewegungen, die es den Ladungsträgern aufzwingt, eine Vergleichmäßigung der Entladung in Richtung der Längsachse des Magnetjoches.

Die dem Plasma ausgesetzten Flächen des Magnetsystems sind vorteilhaft ausgerüstet mit einem einfach abnehmbaren, heizbaren Schild, das in größeren zeitlichen Abständen außerhalb der Anlage gereinigt und ebenso leicht wieder montiert werden kann.

Die Antennenstruktur, durch die die Versorgung der langen Plasmazone mit Mikrowellenenergie erfolgt, kann als Hornantenne ausgeführt werden (siehe Figur 3), durch die das aus dem Hohlleiter austretende Mikrowellenfeld in die Längsrichtung des Magnetsystems ausgeweitet wird. Die größere Öffnung der Hornantenne ist mit einem Quarzfenster 11 abgeschlossen, das als mikrowellendurchlässige Vakuumdichtung für den Rezipienten dient.

Mit Vorteil stellte sich heraus, daß diese Vorrichtung hervorragend als Plasmaquelle für die Beschichtung und Behandlung von Substraten mit kompliziert dreidimensional geformten Oberflächen geeignet ist.

Figuren 1,2, 4 und 5 zeigen verschiedene Einbaumöglichkeiten für die beschriebene Mikrowellenplasmaquelle in Beschichtungsanlagen, die eine zylindrisch geformte Prozeßkammer besitzen, in der ein Drehkäfig mit Planetengetriebe für die zu beschichtenden Teile eingesetzt ist.

Die Plasmaquelle kann in axialer Richtung, parallel zur Kammerlängsachse, wie Figur 1 und 4 zeigen, oder azimutal, wie Figur 5 zeigt, in den Außenmantel des zylindrischen Grundkörpers der Prozeßkammer eingefügt werden. Diese beiden Versionen sind auch für Inline-Anlagen geeignet.

Der Mikrowellensender kann sowohl kontinuierlich als auch gepulst betrieben werden. Als vorteilhaft für die unten beschriebenen Prozesse hat sich der gepulste Betrieb erwiesen. In den Plasma-AUS-Zeiten findet insbesondere an strömungstechnisch ungünstigen Stellen kompliziert geformter dreidimensionaler Substrate ein gewünschter Gasaustausch statt, der eine Vergleichmäßigung von Schichtqualität und Ratenverteilung bewirkt.

Soll die Innenfläche von konkav geformten Substraten beschichtet werden, so müssen im Fall der in axialer Richtung in den Außenmantel gesetzten Plasmaquelle die Winkelgeschwindigkeiten und Phasen der Planetenbewegung in bestimmter Weise aufeinander abgestimmt werden, um optimale Beschichtungsergebnisse zu erzielen.

Die Phasen der Rotation der Planeten um ihre eigene Achse ist durch die Bedingung festgelegt, daß die Fläche der Projektion der zu beschichtenden Innenfläche der konkaven Substrate auf eine Ebene senkrecht zur Beschichtungsrichtung im Augenblick ihrer größten Annäherung an die Beschichtungsquelle maximal ist.

Handelt es sich um eine Batchanlage gemäß Figur 2 und 6 ohne Ausschleuskammer, kann die Plasmaquelle entlang der geometrischen Symmetrieachse des zylindrischen Prozeßkammergrundkörpers angeordnet werden (Figur 6).

Bei Batchanlagen laufen die einzelnen Verfahrensschritte nacheinander ab. Ihr Vorteil besteht in der großen Flexiblität und in der vergleichsweise geringen Umrüstzeit auf ein anderes System. In der Anlage gemäß Figur 2 ist links und rechts je ein Paar von Beschichtungsquellen bzw. ein Kathodenpaar 31 vorgesehen, zwischen dem die auf einem in der Aufsicht kreisförmigen Substratkäfig aufgehängten Teile während der Beschichtung hindurchgeführt werden. Im Ausführungsbeispiel sind Reflektoren auf einem in der Zeichnung nicht dargestellten Träger angeordnet. Die Halterungen zur Aufnahme der Substrate können in vorteilhafter Weise in Segmente aufgeteilt werden. Diese Segmente werden beladen und durchlaufen die Vorreinigung. Das Beladen besteht dann nur noch aus dem Austausch der beschichteten gegen die unbeschichteten Segmente. Durch die vorteilhafte Anordnung kann der Austausch in sehr kurzer Zeit, beispielsweise in einer Minute, erfolgen. Die Chargenzeit hängt von der Anlage und der Schichtdicke des Substrats ab und kann zwischen 10 und 90 Minuten betragen.

Das bisher beschriebene Verfahren ist nicht auf die in der Zeichnung dargestellte Anordnung beschränkt, sondern kann auch noch auf anderen Anlagen eingesetzt werden; beispielsweise kann ein magnetfeldunterstütztes Aufstäuben eintreten (Magnetronsputtern).

Der hier beschriebene Beschichtungsprozeß ist auch in einer Inline-Anlage durchführbar, in der die Substrathalter nicht zwangsläufig eine Rotationsbewegung um eine ihnen gemeinsame Achse ausführen, sondern mittels eines Linearantriebs kontinuierlich in Anlagenlängsrichtung durch die verschiedenen Kammern gefahren werden. Die Plasmaquelle ihrerseits ist so angeordnet, daß ihre Längsachse im rechten Winkel zur Substratbewegungsrichtung verläuft.

Ein weiterer wesentlicher Vorteil der Erfindung ist die Anordnung der Gasverteilungsrohre. Es hat sich erwiesen, daß die in Figur 7 gezeigte Anordnung der Gasverteilungsrohre 17 bei hoher Prozeßsicherheit die besten Schutzschichten erbrachte: die Gasverteilungsrohre, die das jeweils verwendete, Silizium und Kohlenstoff enthaltende Gas dem Prozeß zuführen, werden zwischen den freien Magnetpolen montiert. Wird ein zweites Gas, z.B. Sauerstoff, zusätzlich zum ersten eingesetzt, so kann dies ebenfalls in Jochnähe in die Prozeßkammer eingelassen werden.

Einige der für die Schutz- und die Vorbeschichtungsprozesse verwendeten Organosilizium-Verbindungen besitzen bei Raumtemperatur einen so niedrigen Dampfdruck, daß sie, um die für den Großflächenbeschichtungsprozeß notwendigen Massenflüsse sicherzustellen, auf typisch 70 bis 80°C aufgewärmt und bei diesen Temperaturen in einem geeigneten Verdampfer verdampft (bzw. vergast) werden müssen. Daher sind alle Monomerleitungen, die sich stromabwärts an den Verdampfer anschließen, mittels einer geeigneten Heizung auf eben dieser Temperatur zu halten. Zwecks Vergleichmäßigung der Beschichtung kann das Monomer durch ebenfalls geheizte Gasverteilungrohre in die Prozeßkammer eingelassen werden.

Mittels einer Kaltfläche kann die Saugleistung für leicht kondensierbare Monomere(Prozeßgase), wie z.B. Trifluormethan oder Hexamethyldisiloxan, in einem großen Bereich selektiv variiert werden, ohne daß sich die Saugleistung für Prozeßgase mit niedrigem Taupunkt nennenswert verändert. Die Saugleistung wird über die Temperatur der Kaltfläche und/oder durch ein vorgeschaltetes Ventil reguliert.

Diese Anordnung ermöglicht eine Variation der Prozeßgas/Monomermischungen und der gas-/monomerspezifischen Verweilzeiten der Prozeßgase/Monomere in der Prozeßkammer und damit eine Variation der Schichtzusammensetzung und Schichteigenschaften in einem großen Bereich.

Die Hochvakuumpumpe ist so an die Prozeßkammer angeflanscht, daß die räumliche Verteilung des Saugvermögens in Richtung der Längsachse des Plasmagenerators homogen ist. Das ist der Zweck des in Figur 1 gezeigten Kastens, der die Pumpe mit der Prozeßkammer verbindet. In Verbindung mit homogener Gasversorgung durch die Gasverteilungsrohre und homogener Plasmaerzeugung sind damit die Grundvoraussetzungen für eine ebenso homogene Beschichtung geschaffen. Insbesondere bei der Beschichtung von Formteilen, die zudem noch zusammen mit den immer notwendigen Substrathaltern in einer Planetenbewegung durch die Beschichtungszone hindurchgeführt werden, wird diese Homogenität von eben diesen Substraten jedoch unter Umständen empfindlich gestört. Und zwar ist dies um so ausgeprägter der Fall, je höher der Druck während des Beschichtungsprozesses ist, d.h. je viskoser die Strömungsverhältnisse insbesondere in der Beschichtungszone sind. Mit der eingesetzten Mikrowellen-ECR-Plasmaquelle sind nun besonders niedrige Prozeßdrücke bis herab zu 1 x 10⁻⁴ mbar bis 1 x 10⁻² mbar zugänglich, für die die Strömung zwischen Beschichtungsquelle und Substraten nahezu molekular werden kann. Besonders vorteilhaft ist es, wenn eine Schutzschicht unter Plasma bei Drücken zwischen 8 x 10⁻⁴ mbar bis 2 x 10⁻³ mbar aufgebracht wird.

Die Messung zeigte nun, daß die Depositionsrate bei diesen niedrigen Drücken nicht nur befriedigend hoch war, sondern daß auch - und zwar ebenfalls bei diesen niedrigen Drücken - die Schichtqualität hervorragend war. Aufgrund der oben erläuterten engen, für die vakuumtechnische Großflächenbeschichtung typischen Randbedingungen ist nicht viel Raum für die Optimierung des Prozesses gewesen; insofern war das gute Ergebnis überraschend.

Ebenfalls der Homogenisierung der räumlichen Ratenverteilung auf dreidimensionalen Substraten dient im Fall der Verwendung eines Drehkäfigs die oben schon erwähnte genaue Abstimmung der Phasen und Frequenzen der beiden Rotationsbewegungen, aus denen sich die Planetenbewegung zusammensetzt.

In die Anlage integriert ist eine je nach elektrischer Leitfähigkeit der Substratoberfläche rf- bzw. mf- oder eine DC-Biasversorgung, die über den gegen Masse isolierten Käfig den Substratoberflächen ein positives Potential (selfbias) aufprägt, um auf diese Weise eine ionenunterstützte Abscheidung zu ermöglichen. Damit ist eine ionenunterstützte Abscheidung von besonders dichten und harten Schichten möglich.

Durch den Metallisierungsprozeß kann auch bei dielektrischen Substraten eine leitende Oberfläche erzeugt werden, die gleichzeitig den elektrischen Kontakt zum Drehkäfig herstellt. Damit wird auch bei dielektrischen Substratmaterialien eine ionenunterstützte Abscheidung möglich.

Dem Zweck der Verdichtung und Härtung der sich abscheidenden Schicht dient eine in die Einschleuskammer eingebaute Heizung, mit der die Temperatur ausreichend hitzebeständiger Substrate schon während der Schleusenkonditionierung gesteigert werden kann. In der Prozeßkammer ist eine Halteheizung installiert, die die Substrattemperatur während des Beschichtungsprozesses stabilisiert. Dabei ist auch beabsichtigt, daß sich die Wände und die Einbauten der Prozeßkammer ebenfalls aufheizen. Denn die Folge ist, daß die sich dort abscheidenden Schichten besonders gut haften und sich erst nach deutlich verlängerter Betriebszeit der Anlage von ihrer Unterlage lösen. Die Prozeßkammerheizung verlängert also das Zeitintervall zwischen zwei Reinigungszyklen und also die Produktivität der Gesamtanlage.

In Figur 9 ist eine schematische Darstellung des Substrats 9 mit einer haftvermittelnden Schicht 26, einer Metall- und einer Schutzschicht insbesondere Aluminium-Schicht 27 dargestellt.

Während des Abscheidevorgangs wird auf der Substratoberfläche 25 eine Vorschicht bzw. haftvermittelnde Schicht 26, dann die Metallschicht 27 und anschließend eine dritte Schicht bzw. Schutzschicht 28 unter Plasma bei Drücken unterhalb von 5 x 10⁻¹ mbar aufgebracht. Besonders vorteilhaft ist es, wenn eine Schutzschicht unter Plasma bei Drücken zwischen 8 x 10⁻⁴ mbar bis 2 x 10⁻³ mbar oder 1 x 10⁻⁴ mbar bis 1 x 10⁻¹ mbar aufgebracht wird.

In vorteilhafter Weise wird die erste Schicht bzw. Vorschicht 26 im PCVD-Verfahren, die zweite Schicht 27 im Aufdampfverfahren und die dritte Schicht 28 im PCVD-Verfahren aufgebracht.

Das erfindungsgemäße Verfahren ist in die folgenden Verfahrensschritte zu unterteilen:

Die plasmaunterstützte Behandlung kann beispielsweise bei folgenden Parametern erfolgen:
1. Vorschicht bzw. Haftvermittlungsschicht 26 (Figur 9)
   Als Substratmaterial wird Tedur 9 verwendet.
   - Prozeßdruck 1.0 µbar Hexamethyldisiloxan
   - Mikrowellenleistungsdichte 4.0 Watt/cm² Die Schichtdicke der Vorschicht 26 betrug 100 Å.
2. Zweite Schicht bzw. Metallschicht 27 insbesondere Al
   Die Metallisierung bzw. das Aufdampfen von Aluminium erfolgt in einer Schichtdicke von 800 Å.
3. Schutzschicht 28
   - Prozeßdruck 1.0 µbar Hexamethyldisiloxan
   - Mikrowellenleistungsdichte 4.0 Watt/cm²
   - Schichtdicke vorzugweise 50 Å bis 100 Å Untersucht wurden Schichtdicken gemäß Tabelle bis zu 900 Å.

Die Schutzfunktion wurde nach einem Standardverfahren geprüft (vergl. Figur 8). Die Probe befindet sich in einer Lösung aus Wasser, Alkohol und einem Detergentium. Eine 260 g schwere Bürste wurde mit einer Hubzahl gemäß Tabelle über die Probe gezogen (Standardanordnung des sog. Bürstentests mit einem Gerät der Firma Erichsen). Registriert als Maß für die Schutzwirkung wurde die Hubzahl X gemäß Tabelle, bei der erstmalig eine mit bloßem Auge erkennbare Beschädigung der Unterlage, hier Aluminiumschicht, auftritt. Die Prüfung der angegebenen Proben mit dem Bürstentest ergab folgende Resultate:

**Tabelle 1**

| Schutzdicke Å | Anzahl der Scheuerhübe |
|---|---|
| 900 | 121 |
| 600 | 140 |
| 300 | 231 |
| 100 | 184 |
| 50 | 280 |

Eine zweite Gruppe von Proben, die ebenfalls nach der beschriebenen Methode beschichtet wurden, wurden einige Tage später unter Normalbedingungen gelagert und dann dem Bürstentest unterzogen worden. Das Resultat läßt sich aus der zweiten Tabelle ablesen:

**Tabelle 2**

| Schutzdicke Å | Anzahl der Scheuerhübe |
|---|---|
| 900 | 170 |
| 600 | 200 |
| 300 | 259 |
| 100 | 413 |
| 50 | 522 |

Daraus ergibt sich, daß durch das erfindungsgemäße Verfahren durch eine Schutzschicht 28 mit nur 50 Å eine sehr gute Schutzfunktion erfüllt wird, die darüberhinaus sehr kostengünstig herzustellen ist.

### Bezugszeichenliste

- 1: Vakuumkammer
- 2: Mikrowellenquelle
- 3: Hohlleiter
- 4: Hornantenne
- 5: Verteilerkasten
- 6: Hochvakuumpumpe
- 7: Verdampferbank
- 8: Drehkäfig
- 9: Substrat
- 10: Plasma
- 11: Quarzfenster
- 12: Magnetsystem
- 13: Mikrowellenstruktur
- 14: Koppelelement
- 15: Haltemittel
- 16: Antenne, Antennenstruktur
- 17, 17': Gasverteilungsrohr
- 18: Bohrung
- 19: Magnetpol
- 25: Substratoberfläche
- 26: erste Schicht = Vorschicht (Haftvermittlungsschicht)
- 27: zweite Schicht = Metallschicht (AL-Schicht)
- 28: dritte Schicht = Schutzschicht
- 30: Permanentmagnet
- 31: Kathodenpaar (Beschichtungsquelle)

## Patentansprüche

1. Abriebfestes Schichtsystem auf einem Werkstoff, insbesondere Kunststoff, mit drei Schichten, wobei die erste auf dem Substrat (9) vorgesehene Schicht (26) und die dritte bzw. oberste Schicht (28) neben H und C Si und/oder O enthält, während die zweite Schicht (27) aus Metall besteht, **dadurch gekennzeichnet**, daß die erste und dritte Schicht (26, 28) eine Dicke kleiner als 20 nm aufweisen.

2. Schichtsystem nach Anspruch 1, **dadurch gekennzeichnet**, daß die zweite aus Metall gebildete Schicht (27) eine Dicke zwischen 80 und 100 nm aufweist.

3. Schichtsystem nach Anspruch 1, **dadurch gekennzeichnet**, daß die erste zwischen dem Substrat (9) und der zweiten Schicht bzw. Metallschicht (27) vorgesehene Vorschicht (26) eine Schichtdicke aufweist, die kleiner als 5 nm ist.

4. Schichtsystem nach Anspruch 1, **dadurch gekennzeichnet**, daß die dritte Schicht (28), die auf der Metallschicht (27) vorgesehen ist, eine Schichtdicke aufweist, die kleiner als 5 nm ist.

5. Schichtsystem nach einem oder mehreren der vorhergehenden Ansprüche, **dadurch gekennzeichnet**, daß die erste Schicht (26) und/oder die dritte Schicht (28) vorwiegend C enthält.

6. Schichtsystem nach Anspruch 1, **dadurch gekennzeichnet**, daß die erste Schicht (26) und/oder die dritte Schicht (28) vorwiegend C und H und ferner Si und O bis zu einem Verhältnis von jeweils 1:1 zu C enthält.

7. Schichtsystem nach Anspruch 1, **dadurch gekennzeichnet**, daß die erste Schicht (26) und/oder die dritte Schicht (28) einen C-Bestandteil von mehr als 50 % aufweisen.

8. Schichtsystem nach Anspruch 1, **dadurch gekennzeichnet**, daß die erste Schicht (26) und/oder die dritte Schicht (28) einen C-Bestandteil, einen Si-Anteil und einen O-Anteil zu gleichen Teilen enthält.

9. Verfahren zur Herstellung einer Schicht gemäß Anspruch 1, **dadurch gekennzeichnet**, daß auf der Substratoberfläche (25) eine Vorschicht (26), dann die Metallschicht (27) und anschließend eine Schutzschicht (28) unter Plasma bei Drücken unterhalb von 0,5 mbar aufgebracht wird, wobei die Vor- und/oder Schutzschicht mit Hilfe des PCVD-Verfahrens aufgebracht wird, und daß die Glimmentladung mit einem elektrischen Wechselfeld angeregt wird.

10. Verfahren nach Anspruch 9, **dadurch gekennzeichnet**, daß die Glimmentladung mit einer Frequenz im Mikrowellenbereich angeregt wird.

11. Verfahren nach Anspruch 9, **dadurch gekennzeichnet**, daß die erste Schicht bzw. Vorschicht (26) im PCVD-Verfahren, die zweite Schicht (27) im Aufdampfverfahren und die dritte Schicht (28) im PCVD-Verfahren aufgebracht wird.

12. Verfahren nach einem oder mehreren der Ansprüche 9-11, **dadurch gekennzeichnet**, daß die erste Schicht (26) einer Temperierung in Luft bei Temperaturen, insbesondere unter 200 °C, unterzogen wird.

13. Verfahren nach einem oder mehreren der Ansprüche 9-12, **dadurch gekennzeichnet**, daß die erste Schicht (26) und/oder die dritte Schicht (28) bei einem Prozeßdruck zwischen 0,5 µbar und 100 µbar, insbesondere zwischen 1,0 µbar und 30 µbar, mit einem Hexamethyldisiloxan enthaltenden Prozeßgas bei einer Mikrowellenleistungsdichte zwischen 0,3 und 50 Watt/cm², insbesondere 4 Watt/cm², gebildet wird.

14. Verfahren nach einem oder mehreren der Ansprüche 9-13, **dadurch gekennzeichnet**, daß die zweite Schicht (27) als Aluminiumschicht ausgebildet ist und in einer Vakuumkammer (1) bei Drücken unterhalb von 0,05 mbar durchgeführt wird.

15. Verfahren nach einem oder mehreren der Ansprüche 9-14, **dadurch gekennzeichnet**, daß die erste Schicht (26) aus einer Gasatmosphäre auf die Substratoberfläche (25) aufgebracht wird, wobei die Gasatmosphäre Moleküle enthält, die Si,C, und/oder Si,C,O, enthalten.

16. Verfahren nach einem oder mehreren der Ansprüche 9-15, **dadurch gekennzeichnet,** daß eine **Si,C- bzw. Si,C,O**-Schutzschicht bzw. die dritte Schicht in einer in der Vakuumkammer eingestellten O₂-haltigen Atmosphäre auf der Oberfläche oxidiert wird.

17. Verfahren nach einem oder mehreren der Ansprüche 9-16, **dadurch gekennzeichnet**, daß auf der Substratoberfläche (25) eine Vorschicht (26), dann die Metallschicht (27) und anschließend eine Schutzschicht (28) unter Plasma bei Drücken zwischen 0,8 µbar und 2 µbar aufgebracht wird.

18. Verfahren nach einem oder mehreren der Ansprüche 9-17, **dadurch gekennzeichnet**, daß auf der Substratoberfläche (25) eine Vorschicht (26), dann die Metallschicht (27) und anschließend eine Schutzschicht (28) unter Plasma bei Drücken zwischen 0,1 µbar und 0,1 mbar aufgebracht wird.

19. Verfahren nach einem oder mehreren der Ansprüche 9-18, **dadurch gekennzeichnet**, daß die Substrate nach dem Metallisieren ihrer Oberfläche auf eine Vorspannung, insbesondere auf eine negative Vorspannung, gelegt werden.

20. Verfahren nach einem oder mehreren der Ansprüche 9-19, **dadurch gekennzeichnet**, daß die Substrate vor und/oder während des Beschichtungsvorgangs beheizt werden.

21. Verfahren nach einem oder mehreren der Ansprüche 9-20, **dadurch gekennzeichnet**, daß die Energiequelle bzw. der Plasmagenerator im Pulsbetrieb betrieben wird.

## Claims

1. Abrasion-resistant layer system on a material, especially plastic, with three layers, whereby the first layer (26) deposited on the substrate (9) and the third or upper layer (28) contain Si and/or O in addition to H and C, whereas the second layer (27) consists of metal, **characterized in that** the first and third layers (26, 28) have a thickness of less than 20 nm.

2. Layer system according to Claim 1, **characterized in that** the second layer (27) made of metal has a thickness between 80 and 100 nm.

3. Layer system according to Claim 1, **characterized in that** the first prelayer (26) provided between the substrate (9) and the second layer or metal layer (27) has a thickness of less than 5 nm.

4. Layer system according to Claim 1, **characterized in that** the third layer (28) which is provided on the metal layer (27) has a layer thickness of less than 5 nm.

5. Layer system according to one or more of the preceding Claims, **characterized in that** the first layer (26) and/or the third layer (28) contain predominantly carbon.

6. Layer system according to Claim 1, **characterized in that** the first layer (26) and/or the third layer (28) contain predominantly carbon and hydrogen and, moreover, silicon and oxygen up to a ratio to carbon of 1:1.

7. Layer system according to Claim 1, **characterized in that** the first layer (26) and/or the third layer (28) have a carbon percentage of more than 50%.

8. Layer system according to Claim 1, **characterized in that** the first layer (26) and/or the third layer (28) consist of carbon, silicon and oxygen in equal proportions.

9. Process for the production of a layer according to Claim 1, **characterized in that** first a prelayer (26), then a metal layer (27) and subsequently a protective layer are applied onto the substrate surface (25) in a plasma at pressures below 0.5 mbar, whereby this first prelayer and/or protective layer is applied by means of a PCVD process, and in that the glow discharge is excited with an alternating electrical field.

10. Process according to Claim 9, **characterized in that** the glow discharge is excited with a frequency in the microwave range.

11. Process according to Claim 9, **characterized in that** the first layer or prelayer (26) is applied in a PCVD process, the second layer (27) in a vapor deposition process and the third layer (28) in a PCVD-process.

12. Process according to one or more of Claims 9 through 11, **characterized in that** the first layer (26) is subjected to a heat treatment in air at temperatures below 200°C [392°F] in particular.

13. Process according to one or more of Claims 9 through 12, **characterized in that** the first layer (26) and/or the third layer (28) is produced at a process pressure between 0.5 µbar and 100 µbar, especially between 1.0 µbar and 30 µbar, with a process gas containing hexamethyldisiloxane at a microwave power density between 0.3 and 50 watt/cm², especially 4 watt/cm².

14. Process according to one or more of Claims 9 through 13, **characterized in that** the second layer (27) is configured as an aluminum layer and that it is formed in a vacuum chamber (1) at pressures below 0.05 mbar.

15. Process according to one or more of Claims 9 through 14, **characterized in that** the first layer (26) is applied from a gas atmosphere onto the substrate surface (25), whereby the gas atmosphere contains molecules that contain Si, C and/or Si, C, O.

16. Process according to one or more of Claims 9 through 15, **characterized in that** the surface of a Si, C or Si, C, O protective layer or the third layer is oxidized in an O₂ atmosphere established in the vacuum chamber.

17. Process according to one or more of Claims 9 through 16, **characterized in that** a prelayer (26), then the metal layer (27) and subsequently a protective layer (28) are applied onto the substrate surface (25) in a plasma at pressures between 0.8 µbar and 2 µbar.

18. Process according to one or more of Claims 9 through 17, **characterized in that** a prelayer (26), then the metal layer (27) and subsequently a protective layer (28) are applied onto the substrate surface (25) in a plasma at pressures between 0.1 µbar and 0. mbar.

19. Process according to one or more of Claims 9 through 18, **characterized in that**, after the metallization of their surfaces, the substrates are connected to a prevoltage, especially a negative prevoltage.

20. Process according to one or more of Claims 9 through 19, **characterized in that** substrates are heated before and/or during the coating process.

21. Process according to one or more of Claims 9 through 20, **characterized in that** the energy source or the plasma generator operate in a pulsed mode.

## Revendications

1. Système de couches appliqué sur un matériau, notamment la matière plastique, comportant trois couches, la première couche (26) prévue sur le substrat (9) et la troisième couche, à savoir la couche supérieure (28) contenant en plus de H et de C, Si et/ou O, tandis que la deuxième couche (27) est en métal, **caractérisé en ce que** la première et la troisième couche (26, 28) sont d'une épaisseur inférieure à 20 nm.

2. Système de couches suivant la revendication 1, **caractérisé en ce que** la deuxième couche (27) qui consiste en métal est d'une épaisseur comprise entre 80 et 100 nm.

3. Système de couches suivant la revendication 1, **caractérisé en ce que** la première couche prévue entre le substrat (9) et la deuxième couche qui est la couche métallique (27) est une pré-couche (26) qui présente une épaisseur inférieure à 5 nm.

4. Système de couches suivant la revendication 1, **caractérisé en ce que** la troisièrme couche (28), prévue sur la couche de métal (27), présente une épaisseur inférieure à 5 nm.

5. Système de couches suivant l'une quelconque ou plusieurs des revendications ci-avant, **caractérisé en ce que** la première couche (26) et/ou la troisième couche (28) contiennent essentiellement du C.

6. Système de couches suivant la revendication 1, **caractérisé en ce que** la première couche (26) et/ou la troisième couche (28) contiennent essen-tiellement C et H, et en plus Si et O, chacun jusqu'à une proportion de 1 à 1 par rapport à C.

7. Système de couches suivant la revendication 1, **caractérisé en ce que** la première couche (26) et/ou la troisième couche (28) présentent une part de C de plus de 50%.

8. Système de couches suivant la revendication 1, **caractérisé en ce que** la première couche (26) et/ou la troisième couche (28) présentent une part de C, une portion de Si et une portion de O à parts égales.

9. Procédé pour la fabrication d'une couche conformément à la revendication 1, **caractérisé en ce qu**' on applique sur la surface du substrat (25) une pré-couche (26), puis la couche de métal (27), et enfin une couche de protection (28), sous plasma et à des pressions inférieures à 0,5 mbar, la pré-couche et/ou la couche de protection étant appliquées à l'aide du procédé PCVD, et la décharge lumineuse étant activée par un champ électrique alternatif.

10. Procédé suivant la revendication 9 , **caractérisé en ce que** la décharge à faible lueur soit activée à une fréquence dans la plage des micro-ondes.

11. Procédé suivant la revendication 9, **caractérisé en ce que** la première couche, à savoir la pré-couche (26) est appliquée selon le procédé PCVD, la deuxième couche (27) par métallisation sous vide et la troisième couche (28) selon le procédé PCVD.

12. Procédé suivant l'une quelconque ou plusieurs des revendications 9 à 11, **caractérisé en ce que** la première couche (26) est soumis à un traitement thermique dans une atmosphère d'air à des températures notamment inférieures à 200°C.

13. Procédé suivant l'une quelconque ou plusieurs des revendications 9 à 12, **caractérisé en ce que** la première couche (26) et/ou la troisième couche (28) sont réalisées à une pression de process comprise entre 0,5 µbar et 100 µbar, en particulier entre 1,0 µbar et 30 µbar, avec un gaz de process contenant de l'hexaméthyle-disiloxane à une puissance volumique des micro-ondes comprise entre 0,3 et 50 Watt/cm², en particulier de 4 Watt/cm².

14. Procédé suivant l'une quelconque ou plusieurs des revendications 9 à 13, **caractérisé en ce** que la deuxième couche (27) est une couche d'aluminium produite dans une chambre à vide (1) à des pressions inférieures à 0,05 mbar.

15. Procédé suivant l'une quelconque ou plusieurs des revendications 9 à 14, **caractérisé en ce que** la première couche (26) est appliquée sur la surface du substrat (25) dans une atmosphère de gaz, cette atmosphère de gaz contenant des molécules qui contiennent Si, C et/ou Si, C et O.

16. Procédé suivant l'une quelconque ou plusieurs des revendications 9 à 15, **caractérisé en ce qu**'une couche de protection au Si, C ou au Si, C et O ou la troisième couche est déposée sur la surface par oxydation dans une atmosphère de gaz contenant de l'O₂ ajustée dans la chambre à vide.

17. Procédé suivant l'une quelconque ou plusieurs des revendications 9 à 16, **caractérisé en ce qu**' on applique sur la surface du substrat (25) une pré-couche (26), puis la couche de métal (27), et enfin une couche de protection (28) sous plasma à des pressions comprises entre 0,8 µbar et 2 µbar.

18. Procédé suivant l'une quelconque ou plusieurs des revendications 9 à 17, **caractérisé en ce qu**'on applique sur la surface du substrat (25) une pré-couche (26), puis la couche de métal (27), et enfin une couche de protection (28) sous plasma à des pressions comprises entre 0,1 µbar et 0,1 mbar.

19. Procédé suivant l'une quelconque ou plusieurs des revendications 9 à 18, **caractérisé en ce qu**'une tension de polarisation, notamment une tension de polarisation négative, est appliquée aux substrats après métallisation de leur surface.

20. Procédé suivant l'une quelconque ou plusieurs des revendications 9 à 19, **caractérisé en ce que** les substrats sont chauffés avant et/ou pendant le processus d'enduction.

21. Procédé suivant l'une quelconque ou plusieurs des revendications 9 à 20, **caractérisé en ce que** la source d'énergie, à savoir le générateur de plasma, opère en régime par impulsions.
